# EUROPEAN PATENT APPLICATION

(11) **EP 3 902 137 A1**
(43) Date of publication of application: **27.10.2021**
(21) Application number: 19900924.2
(22) Date of filing: 15.11.2019
(51) Int. Cl.: H03H 7/01

(54) **BAND-PASS FILTER AND METHOD FOR IMPROVING SUPPRESSION LEVEL THEREOF, DUPLEXER AND ELECTRONIC DEVICE**

(30) Priority: 18.12.2018 CN 201811550563
(71) Applicant: Tianjin University, Tianjin 300072 (CN); Rofs Microsystem (Tianjin) Co., Ltd, Tianjin 300462 (CN)
(72) Inventor: PANG, Wei, Tianjin 300072 (CN); WANG, Lei, Tianjin 300462 (CN); ZHENG, Yunzhuo, Tianjin 300462 (CN)
(74) Representative: Bandpay & Greuter
(86) International application number: PCT/CN2019/114195
(87) International publication number: WO 2020/125208

(57) **Abstract**

The present disclosure relates to a band pass filter, including: a series branch resonator unit having a plurality of series resonators; and a parallel branch resonator unit having a plurality of parallel resonators, wherein one end of each parallel resonator is connected to the port of the corresponding series resonator, and the other end is adapted to be connected to a ground terminal through a corresponding grounding inductor, wherein the band pass filter further includes a coupling circuit unit. The coupling circuit unit includes: an equipotential body; a first coupling capacitor, wherein the first end of the first coupling capacitor is connected to the equipotential body, and the second end of the first coupling capacitor is connected to the port of one series resonator; and a second coupling capacitor, wherein the first end of the second coupling capacitor is connected to the equipotential body, and the second end of the second coupling capacitor is connected to a non-grounding port of the corresponding grounding inductor of one parallel resonator. The present disclosure further relates to a method for improving the suppression level of a filter, a duplexer with the band pass filter, and electronic equipment with the band pass filter.

## Description

### Technical Field

Embodiments of the present disclosure relate to the field of semiconductors, in particular to a band pass filter for improving suppression, a method for improving the suppression level of a filter, a duplexer with the band pass filter, and electronic equipment with the band pass filter.

### Background Art

With the rapid development of the wireless communication technology nowadays, the application of miniaturized portable terminal equipment has become increasingly widespread, and accordingly, the demand for high-performance and small-size radio frequency front end modules and devices is also increasingly urgent. In recent years, filter devices such as filters and duplexers based on film bulk acoustic resonators (referred to as FBAR) have become more and more popular in the market. On one hand, it is due to the excellent electrical properties, such as low insertion loss, steep transition characteristics, high selectivity, high power capacity and strong electrostatic discharge (ESD) resistance. On the other hand, it is also due to the characteristics of small volume and easy integration.

At present, in the face of increasingly stringent frequency resources, it is required that the suppression levels of frequency selective devices such as filters and duplexers of radio frequency front ends on adjacent frequency bands are higher and higher. The FBAR devices also need to be improved and enhanced in this regard. It is not only necessary to improve the stop band suppression level without generating greater impact on the pass band insertion loss, and at the same time, it is also necessary to not increase the overall size of a chip or device as much as possible.

The common method is to add an inductor with a large inductance value on a series-parallel branch to change the resonance frequency of a resonator so as to improve the stop band suppression, or to add a notch to improve the stop band suppression. However, all these methods require the addition of additional reactive elements, and the values of these elements are usually relatively large, which is very difficult to be implemented on the chip. If it is realized by winding wires on a substrate or adding discrete elements at the outside of the chip, the number and size of the substrates are inevitably increased, which will inevitably lead to an increase in the overall size of the filter or the duplexer. Moreover, the added winding wires or discrete elements are not ideal in practice, and the introduced losses will be superimposed on the filter, leading to the deterioration of the pass band insertion loss of the filter.

Therefore, the above-mentioned method in the prior art will lead to the increase in the loss of the chip and the substantial expansion of the overall size of the chip while improving the stop band suppression.

### Summary of the Invention

In order to alleviate or solve at least one aspect of the above-mentioned problems in the use of the prior art, the present disclosure is proposed.

The present disclosure proposes a special filter architecture, which can significantly improve the suppression level of adjacent frequency band signals without increasing the loss or significantly increasing the overall size of a chip, by utilizing the coupling between a resonator and an equipotential body.

According to one aspect of an embodiment of the present disclosure, a band pass filter is proposed, including:
a series branch resonator unit having a plurality of series resonators; and
a parallel branch resonator unit having a plurality of parallel resonators, wherein one end of each parallel resonator is connected to the port of the corresponding series resonator, and the other end is adapted to be connected to a ground terminal through a corresponding grounding inductor,
wherein:
   the band pass filter further includes a coupling circuit unit, and the coupling circuit unit includes:
   an equipotential body;
   a first coupling capacitor, wherein the first end of the first coupling capacitor is connected to the equipotential body, and the second end of the first coupling capacitor is connected to a port of one series resonator; and
   a second coupling capacitor, wherein the first end of the second coupling capacitor is connected to the equipotential body, and the second end of the second coupling capacitor is connected to a non-grounding port of the corresponding grounding inductor of one parallel resonator.

Optionally, another series resonator is further disposed between the parallel resonator to which the second end of the second coupling capacitor is connected and the series resonator to which the second end of the first coupling capacitor is connected.

Further optionally, the band pass filter has at least two ground terminals, and the ground terminal to which the second end of the second coupling capacitor is connected or corresponds is different from the ground terminal to which the parallel resonator adjacent to the series resonator, which is connected to the second end of the first coupling capacitor, is connected or corresponds.

Further, at least two parallel resonators among the plurality of parallel resonators share the same ground terminal.

Optionally, the resonator in the band pass filter comprises a film bulk acoustic resonator.

Optionally, in the above-mentioned band pass filter, the band pass filter has a protection ring located at the periphery of a chip pattern area of the band pass filter, and the protection ring constitutes the equipotential body. Further, the first coupling capacitor and/or the second coupling capacitor is formed by an overlapping area between the electrode of the corresponding resonator and the protection ring, as well as a dielectric layer therebetween; or the first coupling capacitor and/or the second coupling capacitor is obtained by adjusting the distance between the electrode of the corresponding resonator and the protection ring; or the first coupling capacitor and/or the second coupling capacitor is formed by an interdigital structure between the corresponding resonator and the protection ring.

Optionally, in the above-mentioned band pass filter, the band pass filter has a first conductive body disposed in the chip pattern area of the band pass filter, and the first conductive body constitutes the equipotential body. Further, the first coupling capacitor and/or the second coupling capacitor is formed by the overlapping area between the electrode of the corresponding resonator and the first conductive body, as well as the dielectric layer therebetween; or the first coupling capacitor and/or the second coupling capacitor is obtained by adjusting the distance between the electrode of the corresponding resonator and the first conductive body; or the first coupling capacitor and/or the second coupling capacitor is formed by the interdigital structure between the corresponding resonator and the first conductive body.

Optionally, in the above-mentioned band pass filter, the band pass filter has a chip packaging part, and the chip packaging part is provided with a second conductive body; the band pass filter is provided with two electrical connection through hole structures, and the two electrical connection through hole structures are electrically connected to the second conductive body respectively; and the two electrical connection through hole structures and the second conductive body constitute the equipotential body. Further, the first coupling capacitor and/or the second coupling capacitor is formed by the overlapping area between the electrode of the corresponding resonator and the electrical connection through hole structure, as well as the dielectric layer therebetween; or the first coupling capacitor and/or the second coupling capacitor is obtained by adjusting the distance between the electrode of the corresponding resonator and the corresponding electrical connection through hole structure; or the first coupling capacitor and/or the second coupling capacitor is obtained by the interdigital structure between the corresponding resonator and the corresponding electrical connection through hole structure.

According to another aspect of the embodiment of the present disclosure, a band pass filter is proposed, including:
a series branch resonator unit having a plurality of series resonators; and
a parallel branch resonator unit having a plurality of parallel resonators, wherein one end of each parallel resonator is connected to the port of the corresponding series resonator, and the other end is adapted to be connected to a ground terminal through a corresponding grounding inductor,
wherein:

   the band pass filter further includes a coupling circuit unit, and the coupling circuit unit includes:
   an equipotential body;
   a first coupling capacitor, wherein the first end of the first coupling capacitor is connected to the equipotential body, and the second end of the first coupling capacitor is connected to a non-grounding port of the corresponding grounding inductor of one parallel resonator; and
   a second coupling capacitor, wherein the first end of the second coupling capacitor is connected to the equipotential body, and the second end of the second coupling capacitor is connected to a non-grounding port of the corresponding grounding inductor of another parallel resonator.

Optionally, the one parallel resonator is not adjacent to the other parallel resonator; and the one parallel resonator and the other parallel resonator do not share the same ground terminal.

Further, the grounding inductor to which the one parallel resonator is connected is not adjacent to the grounding inductor to which the other parallel resonator is connected.

Further, at least two parallel resonators among the plurality of parallel resonators share the same ground terminal.

Optionally, the resonator in the band pass filter comprises a film bulk acoustic resonator.

Optionally, in the above-mentioned band pass filter, the band pass filter has a protection ring located at the periphery of a chip pattern area of the band pass filter, and the protection ring constitutes the equipotential body. Further, the first coupling capacitor and/or the second coupling capacitor is formed by an overlapping area between the electrode of the corresponding resonator and the protection ring, as well as a dielectric layer therebetween; or the first coupling capacitor and/or the second coupling capacitor is obtained by adjusting the distance between the electrode of the corresponding resonator and the protection ring; or the first coupling capacitor and/or the second coupling capacitor is formed by an interdigital structure between the corresponding resonator and the protection ring.

Optionally, in the above-mentioned band pass filter, the band pass filter has a first conductive body disposed in the chip pattern area of the band pass filter, and the first conductive body constitutes the equipotential body. Further, the first coupling capacitor and/or the second coupling capacitor is formed by the overlapping area between the electrode of the corresponding resonator and the first conductive body, as well as the dielectric layer therebetween; or the first coupling capacitor and/or the second coupling capacitor is obtained by adjusting the distance between the electrode of the corresponding resonator and the first conductive body; or the first coupling capacitor and/or the second coupling capacitor is formed by the interdigital structure between the corresponding resonator and the first conductive body.

Optionally, in the above-mentioned band pass filter, the band pass filter has a chip packaging part, and the chip packaging part is provided with a second conductive body; the band pass filter is provided with two electrical connection through hole structures, and the two electrical connection through hole structures are electrically connected to the second conductive body respectively; and the two electrical connection through hole structures and the second conductive body constitute the equipotential body. Further, the first coupling capacitor and/or the second coupling capacitor is formed by the overlapping area between the electrode of the corresponding resonator and the electrical connection through hole structure, as well as the dielectric layer therebetween; or the first coupling capacitor and/or the second coupling capacitor is obtained by adjusting the distance between the electrode of the corresponding resonator and the corresponding electrical connection through hole structure; or the first coupling capacitor and/or the second coupling capacitor is obtained by the interdigital structure between the corresponding resonator and the corresponding electrical connection through hole structure.

The embodiment of the present disclosure further relates to a method for improving the suppression level of a filter. The filter is the above-mentioned band pass filter, and in the band pass filter: the first end of the first coupling capacitor is connected to the equipotential body, and the second end of the first coupling capacitor is connected to the port of one series resonator; and the first end of the second coupling capacitor is connected to the equipotential body, and the second end of the second coupling capacitor is connected to the non-grounding port of the corresponding grounding inductor of one parallel resonator. The method includes the step of adjusting at least one of the first coupling capacitor and the second coupling capacitor, so that the transmission zero point of a signal moves from the roll-off edge frequency on the right side edge of a pass band of the filter to high frequency.

The embodiment of the present disclosure further relates to a method for improving the suppression level of a filter. The filter is the above-mentioned band pass filter, and in the band pass filter: the first end of the first coupling capacitor is connected to the equipotential body, and the second end of the first coupling capacitor is connected to the non-grounding port of the corresponding grounding inductor of one parallel resonator; and the first end of the second coupling capacitor is connected to the equipotential body, and the second end of the second coupling capacitor is connected to the non-grounding port of the corresponding grounding inductor of another parallel resonator. The method includes the step of adjusting at least one of the first coupling capacitor and the second coupling capacitor, so that the transmission zero point of a signal moves from the roll-off edge frequency on the left side edge of a pass band of the filter to low frequency.

The embodiment of the present disclosure further relates to a duplexer, including: a transmitting filter; and a receiving filter. The transmitting filter includes the above-mentioned band pass filter, and in the band pass filter: the first end of the first coupling capacitor is connected to the equipotential body, and the second end of the first coupling capacitor is connected to the port of one series resonator; and the first end of the second coupling capacitor is connected to the equipotential body, and the second end of the second coupling capacitor is connected to the non-grounding port of the corresponding grounding inductor of one parallel resonator. The receiving filter includes the above-mentioned band pass filter, and in the band pass filter: the first end of the first coupling capacitor is connected to the equipotential body, and the second end of the first coupling capacitor is connected to the non-grounding port of the corresponding grounding inductor of one parallel resonator; and the first end of the second coupling capacitor is connected to the equipotential body, and the second end of the second coupling capacitor is connected to the non-grounding port of the corresponding grounding inductor of another parallel resonator.

The embodiment of the present disclosure further relates to electronic equipment, having the above-mentioned band pass filter.

### Brief Description of the Drawings

The following description and drawings can better help understand these and other features and advantages in various embodiments disclosed in the present disclosure. The same reference signs in the figures always indicate the same components, wherein:
Fig. 1 is a schematic structural diagram of a filter in the prior art;
Fig. 2 is a schematic diagram of a filter according to an exemplary embodiment of the present disclosure;
Fig. 3a, Fig. 3b and Figs. 4a-4f are schematic diagrams of modified embodiments of the filter in Fig. 2 respectively;
Fig. 5 is a schematic diagram of a filter according to another exemplary embodiment of the present disclosure;
Figs. 6a-6d are schematic diagrams of modified embodiments of the filter in Fig. 5 respectively;
Fig. 7 schematically shows the arrangement of resonators in a chip, wherein a first coupling capacitor and a second coupling capacitor are exemplarily shown, and a protection ring is used as an equipotential body;
Figs. 8a-8c exemplarily show several different implementation modes of the first coupling capacitor and the second coupling capacitor in Fig. 7 respectively;
Fig. 9 schematically shows the arrangement of the resonators in the chip, wherein the first coupling capacitor and the second coupling capacitor are exemplarily shown, and a first conductive body is used as the equipotential body;
Figs. 10a-10c exemplarily show several different implementation modes of the first coupling capacitor and the second coupling capacitor in Fig. 9 respectively;
Fig. 11a is a three-dimensional schematic diagram of a packaging structure disposed on the chip, wherein the relationship among the equipotential body, the first coupling capacitor and the second coupling capacitor is exemplarily shown;
Fig. 11b is a schematic top view of the chip in Fig. 11a after the packaging structure is removed;
Figs. 12a-12c exemplarily show several different implementation modes of the first coupling capacitor and the second coupling capacitor in Fig. 11b respectively;
Fig. 13a is a schematic structural diagram of a duplexer to which the filter structure of the present disclosure is applied as an exemplary embodiment of the present disclosure;
Fig. 13b is a schematic structural diagram of a duplexer in the prior art;
Fig. 14a exemplarily shows a transmission characteristic curve of a transmitting filter of the duplexer in Fig. 13a and Fig. 13b, wherein the thick line corresponds to the transmitting filter of the duplexer in Fig. 13a, and the thin line corresponds to the transmission characteristic curve of the transmitting filter of the duplexer in Fig. 13b;
Fig. 14b is an enlarged view of a boxed part in Fig. 14a;
Fig. 15a exemplarily shows the transmission characteristic curve of a receiving filter of the duplexer in Fig. 13a and Fig. 13b, wherein the thick line corresponds to the receiving filter of the duplexer in Fig. 13a, and the thin line corresponds to the transmission characteristic curve of the receiving filter of the duplexer in Fig. 13b; and
Fig. 15b is an enlarged view of the box part in Fig. 15a.

### Detailed Description of the Embodiments

The technical solutions of the present disclosure will be further described below in detail through the embodiments and in conjunction with the drawings. In the specification, the same or similar reference signs indicate the same or similar components. The following description of the embodiments of the present disclosure with reference to the drawings is intended to explain the general inventive concept of the present disclosure, and should not be construed as a limitation to the present disclosure.

The present disclosure proposes a filter, which can improve the suppression level of adjacent frequency band signals without causing an increase in pass band insertion loss. In addition, the filter does not have problems such as a substantial increase in the overall size of a chip and an increase in the complexity of the manufacturing process due to the introduction of additional discrete reactive devices, thereby saving the space and reducing the cost.

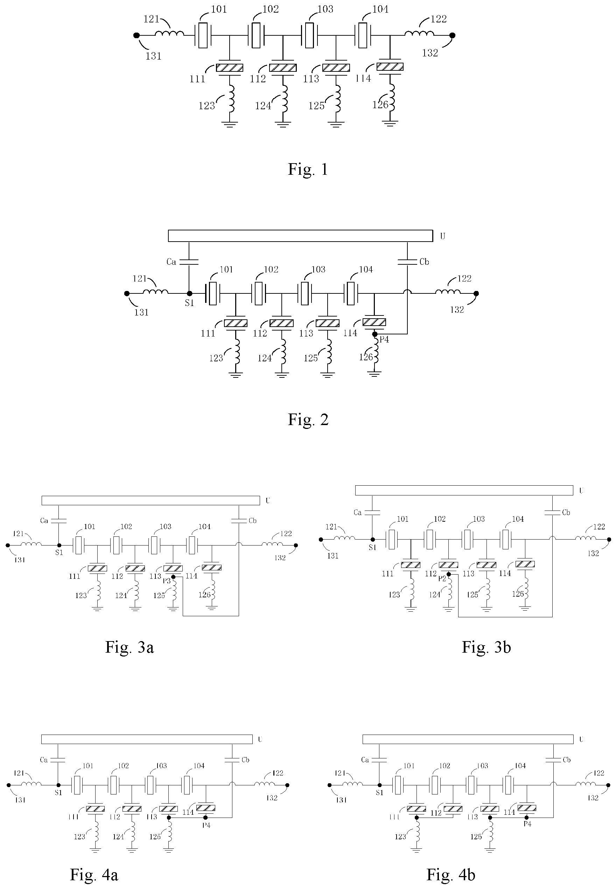

The existing trapezoidal architecture filter structure based on FBAR is shown in Fig. 1. A port 131 is a signal input (or output) port, a port 132 is a signal output (or input) port, and a signal to be filtered is input from the port 131 (or 132) and is output from the port 132 (or 131). A series inductor 121 is connected between the port 131 and a resonator 101, and a series inductor 122 is connected between the port 132 and a resonator 104. Series branch resonators 101, 102, 103 and 104 are connected in series between the series inductor 121 and the series inductor 122. One port of a parallel branch resonator 111 is connected to a position between the series branch resonators 101 and 102, and the other port is connected to one port of a grounding inductor 123. One port of a parallel branch resonator 112 is connected to a position between the series branch resonators 102 and 103, and the other port is connected to one port of a grounding inductor 124. One port of a parallel branch resonator 113 is connected to a position between the series branch resonators 103 and 104, and the other port is connected to one port of a grounding inductor 125. One port of a parallel branch resonator 114 is connected to a position between the series branch resonator 104 and the series inductor 122, and the other port is connected to one port of a grounding inductor 126. The other ports of the grounding inductors 123, 124, 125 and 126 are all grounded. The resonance frequency fs of the series branch resonators 101, 102, 103 and 104 is higher than the resonance frequency fs' of the parallel branch resonators.

Fig. 2 is a schematic diagram of a filter according to an exemplary embodiment of the present disclosure. The filter can improve the suppression level of a high frequency near stop band above the roll-off edge frequency on the right side of a pass band.

In Fig. 2, the port 131 is a signal input (or output) port, the port 132 is a signal output (or input) port, and the signal to be filtered is input from the port 131 (or 132) and is output from the port 132 (or 131). The series inductor 121 is connected between the port 131 and the resonator 101, and the series inductor 122 is connected between the port 132 and the resonator 104. The series branch resonators 101, 102, 103 and 104 are connected in series between the series inductor 121 and the series inductor 122. One port of the parallel branch resonator 111 is connected to the position between the series branch resonators 101 and 102, and the other port is connected to one port of the grounding inductor 123. One port of the parallel branch resonator 112 is connected to the position between the series branch resonators 102 and 103, and the other port is connected to one port of the grounding inductor 124. One port of the parallel branch resonator 113 is connected to the position between the series branch resonators 103 and 104, and the other port is connected to one port of the grounding inductor 125. One port of the parallel branch resonator 114 is connected to the position between the series branch resonator 104 and the series inductor 122, and the other port is connected to one port of the grounding inductor 126. The other ports of the grounding inductors 123, 124, 125 and 126 are all grounded. In Fig. 2, a coupling capacitor Ca is added between an equipotential body U and a node SI; and a coupling capacitor Cb is added between the equipotential body U and a node P4.

In Fig. 2, the respective resonance frequency fs of the series branch resonators 101 to 104 can be the same or not completely the same, and the respective resonance frequency fs' of the parallel branch resonators 111 to 114 can be the same or not completely the same. The resonance frequency fs of each series branch resonator is higher than the resonance frequency fs' of each parallel branch resonator.

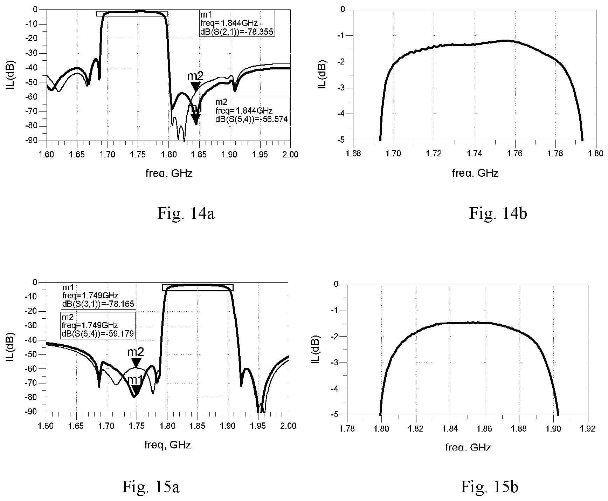

The equipotential body U and the capacitors Ca and Cb form a signal coupling circuit structure or a coupling circuit unit. In Fig. 2, due to the addition of the signal coupling circuit structure, the transmission zero point of the signal moves from the roll-off edge frequency on the right side edge of the pass band of the filter to high frequency. The amount of movement can be controlled by adjusting the numerical values of Ca and Cb. In this way, as long as Ca and Cb are adjusted to move the transmission zero point to the required frequency in the high frequency near stop band, the suppression level in the vicinity of the frequency can be improved. In the present disclosure, Ca and Cb are respectively implemented in the vicinity of the two nodes of S1 and P4, and then the equipotential body U is implemented by some methods, so that the three components form a complete signal coupling circuit. In addition, because the capacitors Ca and Cb can be adjusted separately, so the implementation flexibility is also improved while solving the implementability. The specific technical effects that can be achieved by using this structure will be described in detail in the following embodiments, and reference can be made to Fig. 14a and Fig. 14b.

It should be particularly noted that, the connection mode of the coupling capacitors Ca and Cb connected to the equipotential body U in Fig. 2 is not unique, and one port of the capacitor Cb can also be connected to other nodes other than P4.

In a further embodiment, the coupling capacitor Ca is connected between a port node of a certain series resonator and the equipotential body, the coupling capacitor Cb is connected between a connection node of a certain parallel resonator connecting with the corresponding grounding inductor and the equipotential body, and the parallel resonator is not adjacent to the series resonator; and in a further embodiment, the certain parallel resonator and a parallel resonator adjacent to the certain series resonator are not grounded through a common grounding inductor.

Fig. 3a and Fig. 3b show two variants of the embodiment in Fig. 2.

The example given in Fig. 2 is a situation where four parallel branch resonators are respectively grounded through corresponding grounding inductors. According to design needs, some parallel branch resonators can also be combined and grounded through a common grounding inductor. Some modified embodiments in this case are shown in Figs. 4a-4f.

In Fig. 4a, if the port of the coupling capacitor Cb is not connected to the node P4, but is connected to the node where the parallel resonator 113 and the grounding inductor 125 are connected, or to the node where the parallel resonator 112 and the grounding inductor 124 are connected, the effect of improving the suppression level of the present disclosure can also be achieved.

In Fig. 4b, if the port of the coupling capacitor Cb is not connected to the node P4, but is connected to the node where the parallel resonator 113 and the grounding inductor 125 are connected, the effect of improving the suppression level of the present disclosure can also be achieved.

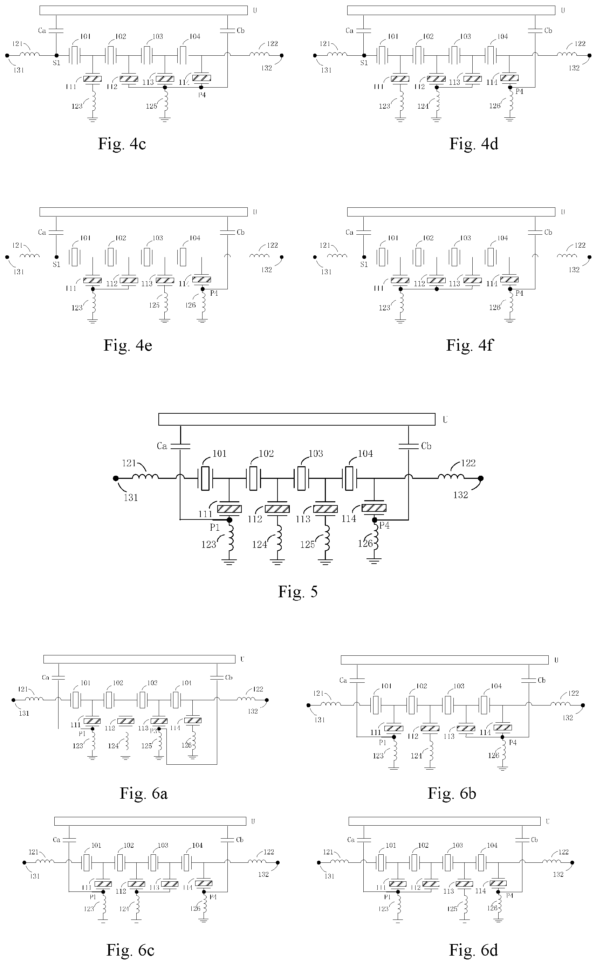

In Fig. 4c, if the port of the coupling capacitor Cb is not connected to the node P4, but is connected to the node where the parallel resonator 113 and the grounding inductor 125 are connected, or to the node where the parallel resonator 112 and the grounding inductor 125 are connected, the effect of improving the suppression level of the present disclosure can also be achieved.

In Fig. 4d, if the port of the coupling capacitor Cb is not connected to the node P4, but is connected to the node where the parallel resonator 113 and the grounding inductor 124 are connected, or to the node where the parallel resonator 112 and the grounding inductor 124 are connected, the effect of improving the suppression level of the present disclosure can also be achieved.

In Fig. 4e, if the port of the coupling capacitor Cb is not connected to the node P4, but is connected to the node where the parallel resonator 113 and the grounding inductor 125 are connected, the effect of improving the suppression level of the present disclosure can also be achieved.

In Fig. 4f, if the port of Cb is not connected to the node P4, but is connected to whichever node where the parallel resonators 111, 112 and 113 and the corresponding grounding inductor 123 are connected, although the connection rules are not met, it can also help improve the suppression level.

Based on the above description, the present disclosure proposes a band pass filter, including:
a series branch resonator unit having a plurality of series resonators; and
a parallel branch resonator unit having a plurality of parallel resonators, wherein one end of each parallel resonator is connected to the port of the corresponding series resonator, and the other end is adapted to be connected to a ground terminal through a corresponding grounding inductor,
wherein:

   the band pass filter further includes a coupling circuit unit, and the coupling circuit unit includes:
   an equipotential body;
   a first coupling capacitor, wherein the first end of the first coupling capacitor is connected to the equipotential body, and the second end of the first coupling capacitor is connected to the port of one series resonator; and
   a second coupling capacitor, wherein the first end of the second coupling capacitor is connected to the equipotential body, and the second end of the second coupling capacitor is connected to a non-grounding port of the corresponding grounding inductor of one parallel resonator.

Based on the structure in Fig. 1, the present disclosure further proposes a filter structure in Fig. 5 that can improve the suppression level. The filter structure can improve the suppression level of a low frequency near stop band below the roll-off edge frequency on the left side of the pass band.

In Fig. 5, the port 131 is a signal input (or output) port, the port 132 is a signal output (or input) port, and the signal to be filtered is input from the port 131 (or 132) and is output from the port 132 (or 131). The series inductor 121 is connected between the port 131 and the resonator 101, and the series inductor 122 is connected between the port 132 and the resonator 104. The series branch resonators 101, 102, 103 and 104 are connected in series between the series inductor 121 and the series inductor 122. One port of the parallel branch resonator 111 is connected to the position between the series branch resonators 101 and 102, and the other port is connected to one port of the grounding inductor 123. One port of the parallel branch resonator 112 is connected to the position between the series branch resonators 102 and 103, and the other port is connected to one port of the grounding inductor 124. One port of the parallel branch resonator 113 is connected to the position between the series branch resonators 103 and 104, and the other port is connected to one port of the grounding inductor 125. One port of the parallel branch resonator 114 is connected to the position between the series branch resonator 104 and the series inductor 122, and the other port is connected to one port of the grounding inductor 126. The other ports of the grounding inductors 123, 124, 125 and 126 are grounded, respectively.

In Fig. 5, the coupling capacitor Ca is further added between the equipotential body U and a node PI; and the coupling capacitor Cb is added between the equipotential body U and the node P4.

In Fig. 5, the respective resonance frequency fs of the series branch resonators 101 to 104 can be the same or not completely the same, and the respective resonance frequency fs' of the parallel branch resonators 111 to 114 can be the same or not completely the same. The resonance frequency fs of each series branch resonator is higher than the resonance frequency fs' of each parallel branch resonator.

The equipotential body U and the coupling capacitors Ca and Cb form a signal coupling circuit structure or a coupling circuit unit. In Fig. 5, due to the addition of the signal coupling circuit structure, the transmission zero point of the signal moves from the roll-off edge frequency on the left side edge of the pass band of the filter to low frequency. The amount of movement can be controlled by adjusting the numerical values of Ca and Cb. In this way, as long as Ca and Cb are adjusted to move the transmission zero point to the required frequency in the low frequency near stop band, the suppression level in the vicinity of the frequency can be improved. Therefore, in the present disclosure, Ca and Cb are respectively implemented in the vicinity of the two nodes of P1 and P4, and then the equipotential body U is implemented by some methods, so that the three components form a complete signal coupling circuit.

In addition, because the coupling capacitors Ca and Cb can be adjusted separately, so the implementation flexibility is also improved while solving the implementability. The specific technical effects that can be achieved by using this special structure will be described in detail in the following embodiments, and reference can be made to Fig. 15a and Fig. 15b.

It should be particularly noted that, the connection mode of the coupling capacitors Ca and Cb in coupling connection with the equipotential body U in Fig. 5 is not unique, and one port of the coupling capacitor Cb can also be connected to other nodes other than P4. Specifically, the coupling capacitor Ca can be connected between the equipotential body U and the node of a certain parallel resonator and the corresponding grounding inductor, and the coupling capacitor Cb is connected between the equipotential body U and the node of another parallel resonator and the corresponding grounding inductor. In an optional embodiment, the two parallel resonators are not adjacent to each other or are not commonly grounded through a common grounding inductor. In a further optional embodiment, the corresponding grounding inductors of the two parallel resonators are also not adjacent to each other.

Figs. 6a-6d show several modified embodiments of Fig. 5 respectively. On the basis of Fig .5, in Fig. 6a, the connection point of the coupling capacitor Cb is changed from P4 into a connection node P3 of the parallel resonator 113 and the inductor 125, which can also achieve the effect of improving the suppression level of the present disclosure.

In Fig. 6b, the parallel resonators 113 and 114 are commonly grounded through the grounding inductor 126, and the coupling capacitor Cb is connected to the node P4, which can also achieve the effect of improving the suppression level of the present disclosure.

In Fig. 6c, if the connection point of the coupling capacitor Cb is moved from the node P4 to the connection node of the parallel resonator 112 or 113 and the grounding inductor 124, the connection rules are not met, but it can also help improve the suppression level.

In Fig. 6d, if the connection point of the coupling capacitor Cb is moved from the node P4 to the connection node of the parallel resonator 113 and the grounding inductor 125, the connection rules are not met, but it can also help improve the suppression level.

It needs to be particularly noted here that: the combination of each series resonator such as 101 and the adjacent parallel resonator such as 111 is called a first stage, so Fig. 2 to Fig. 6d show the examples of a 4-stage FBAR trapezoidal architecture filter. It is only used as an example in the present disclosure to facilitate the detailed description of the details of the present disclosure, and the application scope of the present disclosure is not limited to the situation of 4-stage trapezoidal architecture, but can be applied to any number of stages more or less.

Based on the above description, the present disclosure proposes a band pass filter, including:
a series branch resonator unit having a plurality of series resonators; and
a parallel branch resonator unit having a plurality of parallel resonators, wherein one end of each parallel resonator is connected to the port of the corresponding series resonator, and the other end is adapted to be connected to a ground terminal through a corresponding grounding inductor,
wherein:
   the band pass filter further includes a coupling circuit unit, and the coupling circuit unit includes:
   an equipotential body;
   a first coupling capacitor, wherein the first end of the first coupling capacitor is connected to the equipotential body, and the second end of the first coupling capacitor is connected to a non-grounding port of the corresponding grounding inductor of one parallel resonator; and
   a second coupling capacitor, wherein the first end of the second coupling capacitor is connected to the equipotential body, and the second end of the second coupling capacitor is connected to the non-grounding port of the corresponding grounding inductor of another parallel resonator.

The implementation modes of the equipotential body and the coupling capacitors in the above-mentioned filter structure will be exemplarily illustrated below.

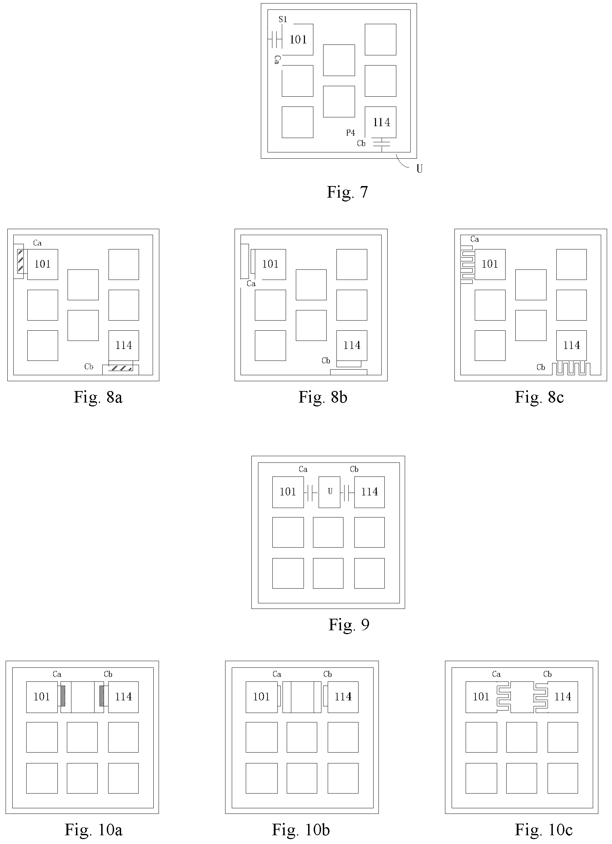

In practice, a protection ring located at the periphery of a chip pattern area of an FBAR chip can be used as the equipotential body U. In terms of the first special structure in Fig. 2, the resonator arrangement in one FBAR chip is shown in Fig. 7, and the protection ring at the periphery is used as the equipotential body U. One side of the series resonator 101 close to the protection ring is the node S1, and the coupling capacitor Ca can be introduced between the series resonator 101 and the protection ring U in someway. One side of the parallel resonator 114 close to the protection ring is the node P4, and the coupling capacitor Cb can be introduced between the parallel resonator 114 and the protection ring U in someway.

In practice, a conductive or first conductive body (pad) with equal potential difference can be added in the pattern area of the FBAR chip to serve as the equipotential body U. In terms of the first special structure in Fig. 2, the resonator arrangement in one FBAR chip is also shown in Fig. 9, and the separately added first conductive body is used as the equipotential body U to introduce the coupling capacitors Ca and Cb.

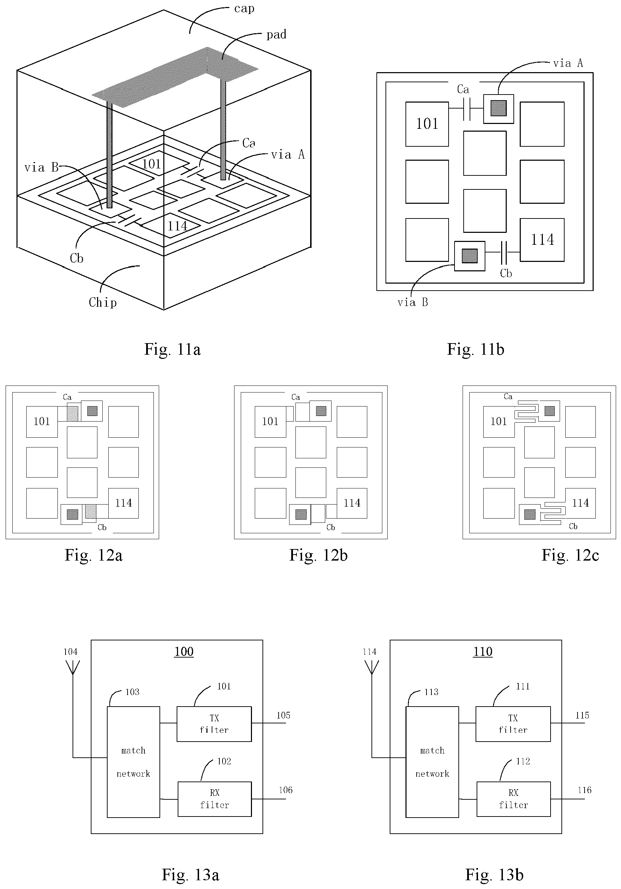

In practice, a through hole via connected to the same conductive body pad on a chip packaging structure cap can also be used as the equipotential body U. In terms of the filter structure shown in Fig. 2, the resonator arrangement in one FBAR chip can also be shown in Fig. 11a, and two through holes via A and via B connected to the same conductive body pad on the packaging structure are used as the equipotential body U to introduce the coupling capacitors Ca and Cb. Fig. 11b is a plane top view of the chip part viewed from top to bottom after the packaging structure cap is omitted.

Figs. 8a-8c show several different implementation modes of the coupling capacitors Ca and Cb in Fig. 7. As shown in Fig. 8a, the coupling capacitors Ca and Cb can be realized by an overlapping area between the electrode of the resonator and the protection ring, as well as a dielectric layer therebetween the two. As shown in Fig. 8b, the coupling capacitors Ca and Cb can be realized by reducing the distance between the electrode of the resonator and the protection ring U to introduce the required coupling capacitors. As shown in Fig. 8c, the coupling capacitors Ca and Cb can also be realized by an interdigital structure between the resonator and the protection ring U.

Figs. 10a-10c show several different implementation modes of Ca and Cb in Fig. 9. As shown in Fig. 10a, the coupling capacitors Ca and Cb can be realized by the overlapping area between the electrode of the resonator and the first conductive body, as well as the dielectric layer therebetween. As shown in Fig. 10b, the coupling capacitors Ca and Cb can be realized by reducing the distance between the electrode of the resonator and the first conductive body pad to introduce the required coupling capacitors. As shown in Fig. 10c, the coupling capacitors Ca and Cb can also be realized by the interdigital structure between the resonator and the first conductive body pad.

Figs. 12a-12c show several different implementation modes of the coupling capacitors Ca and Cb in Fig. 11b. For clarity and conciseness, the plane top view of the chip part viewed from top to bottom is given, and the packaging structure cap is omitted. As shown in Fig. 12a, the coupling capacitors Ca and Cb can be realized by the overlapping area between the electrode of the resonator and the through hole via, as well as the dielectric layer therebetween. As shown in Fig. 12b, the coupling capacitors Ca and Cb can be realized by reducing the distances between the electrode of the resonator and the through holes via A and via B to introduce the required coupling capacitors. As shown in Fig. 12c, the coupling capacitors Ca and Cb can also be realized by the interdigital structure between the resonator and the through holes via A and via B.

Figs.7-12c illustrate the implementation mode of the equipotential body U in practice by taking the filter structure in Fig. 2 as an example. All these implementation modes can also be used for implementing the second special structure in Fig. 5, and no repeated description is given here.

It should be particularly noted that, after the implementation mode of the equipotential body U is determined, the specific implementation modes of the coupling capacitors Ca and Cb can be different. For example, Ca is implemented in the mode in Fig. 8a, while Cb is implemented in the mode in Fig. 8c, which are all within the protection scope of the present disclosure.

Fig. 13a is a schematic structural diagram of a duplexer 100, wherein: 101 represents a transmitting filter (TX filter), and 102 represents a receiving filter (RX filter); one port of the transmitting filter 101 is connected to a port 105, and the port can be connected to external equipment such as a radio frequency signal generating circuit for transmitting a radio frequency signal generated by the external equipment into the transmitting filter 101; the other port of the transmitting filter 101 is connected to a match network (match network) 103 for transmitting the filtered signal into the match network; one port of the receiving filter 102 is connected to a port 106, and the port can be connected to a subsequent circuit such as a low noise amplifier; the other port of the receiving filter 102 is connected to the match network 103 for transmitting the signal received by an antenna into the receiving filter 102; and the match network 103 is connected among the antenna 104, the transmitting filter 101 and the receiving filter 102 for adjusting the impedance matching of the antenna port. In the present embodiment, the transmitting filter 101 comprises, for example, the filter structure shown in Fig. 2 proposed by the present disclosure. The receiving filter 102 comprises, for example, the filter structure shown in Fig. 5 proposed by the present disclosure.

For comparison, the duplexer 110 is also proposed, the schematic structural diagram of which is shown in Fig. 13b, the components and functions are the same as those in Fig. 13a, and thus are not repeated here. The difference lies in that the transmitting filter (TX filter) 111 and the receiving filter (RX filter) 112 use the ordinary trapezoidal architecture shown in Fig. 1 instead of the specific structure given in the present disclosure, and the special signal coupling circuit structure formed by the equipotential body U and the coupling capacitors Ca and Cb is not used.

Based on the above description, the present disclosure proposes a duplexer, including: a transmitting filter; and a receiving filter, wherein the transmitting filter includes the band pass filter, for example, as shown in Fig. 2, and the receiving filter includes the band pass filter, for example, as shown in Fig. 5.

Fig. 14a and Fig. 15a respectively show transmission characteristic curves of the receiving filters and the transmitting filters of the duplexers 100 and 110. For the duplexer in this example, the pass band frequency range of the transmitting filter is 1710MHz-1785MHz, and the center frequency can be considered to be about 1749MHz; the pass band frequency range of the receiving filter is 1805MHz-1880MHz, and the center frequency can be considered to be about 1844MHz. In order to minimize the mutual influence between the two filters, it is necessary to increase the suppression degree of the two filters in the pass bands of each other, especially near the center frequency, as much as possible in the design. In the present embodiment, the duplexer in this frequency band is only used as an example, and the filter structure in the present disclosure is also applicable to duplexers and filters in other frequency bands.

Fig. 14a exemplarily shows the transmission characteristic curves of the transmitting filters 101 and 111, wherein the thick line indicates the performance of the transmitting filter 101, and the thin line indicates the performance of the transmitting filter 111. The circuit structure of the transmitting filter 101 is shown in Fig. 2, the special coupling circuit structure formed by the equipotential body U and the coupling capacitors Ca and Cb is used therein, this structure functions to move the transmission zero point of the signal from the roll-off location on the right side edge of the pass band to a position of about 1844MHz at high frequency, which is basically the same as the center frequency of the receiving filter 102. It can be seen from Fig. 14a that the moved transmission zero point forms a deeper suppression point at 1844MHz, and the suppression level reaches about -78dB (marked by m1 in the figure), and the suppression levels in the vicinity of this point are all significantly improved. For the transmitting filter 111 that does not use the equipotential body U and the coupling capacitor Ca, Cb, its transmission characteristic curve is shown by the thin line, the suppression level at 1844MHz is only about -56dB (marked by m2 in the figure), and the suppression levels in the vicinity of this point are all obviously worse.

In addition, Fig. 14b is an enlarged view of the part in the box in Fig. 14a. It can be seen that the two curves in the pass band completely overlap, which indicates that after the structure proposed by the present disclosure, for example, the structure shown in Fig. 2 is used, the out-of-band suppression is improved, and meanwhile, the insertion loss of the pass band is not deteriorated at all.

Fig. 15a exemplarily shows the transmission characteristic curves of the receiving filters 102 and 112. The thick line indicates the performance of the receiving filter 102, and the thin line indicates the performance of the receiving filter 112. The circuit structure of the receiving filter 102 is shown in Fig. 5, the special coupling circuit structure formed by the equipotential body U and the coupling capacitors Ca and Cb is used therein, this structure functions to move the transmission zero point of the signal from the roll-off location on the left side edge of the pass band to a position of about 1749MHz at low frequency, which is basically the same as the center frequency of the transmitting filter 101. It can be seen from Fig. 15a that the moved transmission zero point forms a deeper suppression point at 1749MHz, and the suppression level reaches about -78dB (marked by m1 in the figure), and the suppression levels in the vicinity of this point are all significantly improved. For the receiving filter 112 that does not use the equipotential body U and the coupling capacitor Ca, Cb, its transmission characteristic curve is shown by the thin line, the suppression level at 1749MHz is only about -59dB (marked by m2 in the figure), and the suppression levels in the vicinity of this point are all obviously worse.

In addition, Fig. 15b is an enlarged view of the part in the box in Fig. 15a. It can be seen that the two curves in the pass band completely overlap, which indicates that after the filter structure proposed by the present disclosure, for example, the structure shown in Fig. 5 is used, the out-of-band suppression is improved, and meanwhile, the insertion loss of the pass band is not deteriorated at all.

Correspondingly, the present disclosure proposes a method for improving the suppression level of a filter. The filter is, for example, the band pass filter shown in Fig. 2, and the method includes the step of:
adjusting at least one of the first coupling capacitor and the second coupling capacitor, so that the transmission zero point of the signal moves from the roll-off edge frequency on the right side edge of the pass band of the filter to high frequency.

The present disclosure further proposes a method for improving the suppression level of a filter. The filter is, for example, the band pass filter shown in Fig. 5, and the method includes the step of:
adjusting at least one of the first coupling capacitor and the second coupling capacitor, so that the transmission zero point of the signal moves from the roll-off edge frequency on the left side edge of the pass band of the filter to low frequency.

The embodiment of the present disclosure further relates to electronic equipment, including the above-mentioned band pass filter. It should be pointed out that the electronic equipment here includes, but not limited to, intermediate products such as radio frequency front ends, filter amplifier modules, and terminal products such as mobile phones, WIFI, and unmanned aerial vehicles.

Although the embodiments of the present disclosure have been shown and described, for those of ordinary skill in the art, it can be understood that these embodiments can be changed without departing from the principle and spirit of the present disclosure, and the scope of the present disclosure is defined by the appended claims and their equivalents.

## Claims

1. A band pass filter, comprising:
a series branch resonator unit having a plurality of series resonators; and
a parallel branch resonator unit having a plurality of parallel resonators, wherein one end of each parallel resonator is connected to the port of the corresponding series resonator, and the other end is adapted to be connected to a ground terminal through a corresponding grounding inductor,
wherein:
the band pass filter further comprises a coupling circuit unit, and the coupling circuit unit comprises:
an equipotential body;
a first coupling capacitor, wherein the first end of the first coupling capacitor is connected to the equipotential body, and the second end of the first coupling capacitor is connected to a port of one series resonator; and
a second coupling capacitor, wherein the first end of the second coupling capacitor is connected to the equipotential body, and the second end of the second coupling capacitor is connected to a non-grounding port of the corresponding grounding inductor of one parallel resonator.

2. The band pass filter according to claim 1, wherein:
another series resonator is further disposed between the parallel resonator to which the second end of the second coupling capacitor is connected and the series resonator to which the second end of the first coupling capacitor is connected.

3. The band pass filter according to claim 2, wherein:
the band pass filter has at least two ground terminals, and the ground terminal to which the second end of the second coupling capacitor is connected or corresponds is different from the ground terminal to which the parallel resonator adjacent to the series resonator, which is connected to the second end of the first coupling capacitor, is connected or corresponds.

4. The band pass filter according to claim 3, wherein:
at least two parallel resonators among the plurality of parallel resonators share the same ground terminal.

5. The band pass filter according to claim 1, wherein:
the resonator in the band pass filter comprises a film bulk acoustic resonator.

6. The band pass filter according to any one of claims 1-5, wherein:
the band pass filter has a protection ring located at the periphery of a chip pattern area of the band pass filter, and the protection ring constitutes the equipotential body.

7. The band pass filter according to claim 6, wherein:
the first coupling capacitor and/or the second coupling capacitor is formed by an overlapping area between the electrode of the corresponding resonator and the protection ring, as well as a dielectric layer therebetween; or
the first coupling capacitor and/or the second coupling capacitor is obtained by adjusting the distance between the electrode of the corresponding resonator and the protection ring; or
the first coupling capacitor and/or the second coupling capacitor is formed by an interdigital structure between the corresponding resonator and the protection ring.

8. The band pass filter according to any one of claims 1-5, wherein:
the band pass filter has a first conductive body disposed in the chip pattern area of the band pass filter, and the first conductive body constitutes the equipotential body.

9. The band pass filter according to claim 8, wherein:
the first coupling capacitor and/or the second coupling capacitor is formed by the overlapping area between the electrode of the corresponding resonator and the first conductive body, as well as the dielectric layer therebetween; or
the first coupling capacitor and/or the second coupling capacitor is obtained by adjusting the distance between the electrode of the corresponding resonator and the first conductive body; or
the first coupling capacitor and/or the second coupling capacitor is formed by the interdigital structure between the corresponding resonator and the first conductive body.

10. The band pass filter according to any one of claims 1-5, wherein:
the band pass filter has a chip packaging part, and the chip packaging part is provided with a second conductive body;
the band pass filter is provided with two electrical connection through hole structures, and the two electrical connection through hole structures are electrically connected to the second conductive body respectively; and
the two electrical connection through hole structures and the second conductive body constitute the equipotential body.

11. The band pass filter according to claim 10, wherein:
the first coupling capacitor and/or the second coupling capacitor is formed by the overlapping area between the electrode of the corresponding resonator and the electrical connection through hole structure, as well as the dielectric layer therebetween; or
the first coupling capacitor and/or the second coupling capacitor is obtained by adjusting the distance between the electrode of the corresponding resonator and the corresponding electrical connection through hole structure; or
the first coupling capacitor and/or the second coupling capacitor is obtained by the interdigital structure between the corresponding resonator and the corresponding electrical connection through hole structure.

12. A band pass filter, comprising:
a series branch resonator unit having a plurality of series resonators; and
a parallel branch resonator unit having a plurality of parallel resonators, wherein one end of each parallel resonator is connected to the port of the corresponding series resonator, and the other end is adapted to be connected to a ground terminal through a corresponding grounding inductor,
wherein:
the band pass filter further comprises a coupling circuit unit, and the coupling circuit unit comprises:
an equipotential body;
a first coupling capacitor, wherein the first end of the first coupling capacitor is connected to the equipotential body, and the second end of the first coupling capacitor is connected to a non-grounding port of the corresponding grounding inductor of one parallel resonator; and
a second coupling capacitor, wherein the first end of the second coupling capacitor is connected to the equipotential body, and the second end of the second coupling capacitor is connected to a non-grounding port of the corresponding grounding inductor of another parallel resonator.

13. The band pass filter according to claim 12, wherein:
the one parallel resonator is not adjacent to the other parallel resonator; and
the one parallel resonator and the other parallel resonator do not share the same ground terminal.

14. The band pass filter according to claim 13, wherein:
the grounding inductor to which the one parallel resonator is connected is not adjacent to the grounding inductor to which the other parallel resonator is connected.

15. The band pass filter according to claim 14, wherein:
at least two parallel resonators among the plurality of parallel resonators share the same ground terminal.

16. The band pass filter according to claim 12, wherein:
the resonator in the band pass filter comprises a film bulk acoustic resonator.

17. The band pass filter according to any one of claims 12-16, wherein:
the band pass filter has a protection ring located at the periphery of a chip pattern area of the band pass filter, and the protection ring constitutes the equipotential body.

18. The band pass filter according to claim 17, wherein:
the first coupling capacitor and/or the second coupling capacitor is formed by an overlapping area between the electrode of the corresponding resonator and the protection ring, as well as a dielectric layer therebetween; or
the first coupling capacitor and/or the second coupling capacitor is obtained by adjusting the distance between the electrode of the corresponding resonator and the protection ring; or
the first coupling capacitor and/or the second coupling capacitor is formed by an interdigital structure between the corresponding resonator and the protection ring.

19. The band pass filter according to any one of claims 12-16, wherein:
the band pass filter has a first conductive body disposed in the chip pattern area of the band pass filter, and the first conductive body constitutes the equipotential body.

20. The band pass filter according to claim 19, wherein:
the first coupling capacitor and/or the second coupling capacitor is formed by the overlapping area between the electrode of the corresponding resonator and the first conductive body, as well as the dielectric layer therebetween; or
the first coupling capacitor and/or the second coupling capacitor is obtained by adjusting the distance between the corresponding resonator and the first conductive body; or
the first coupling capacitor and/or the second coupling capacitor is formed by the interdigital structure between the corresponding resonator and the first conductive body.

21. The band pass filter according to any one of claims 12-16, wherein:
the band pass filter has a chip packaging part, and the chip packaging part is provided with a second conductive body;
the band pass filter is provided with two electrical connection through hole structures, and the two electrical connection through hole structures are electrically connected to the second conductive body respectively; and
the two electrical connection through hole structures and the second conductive body constitute the equipotential body.

22. The band pass filter according to claim 21, wherein:
the first coupling capacitor and/or the second coupling capacitor is formed by the overlapping area between the electrode of the corresponding resonator and the electrical connection through hole structure, as well as the dielectric layer therebetween; or
the first coupling capacitor and/or the second coupling capacitor is obtained by adjusting the distance between the electrode of the corresponding resonator and the corresponding electrical connection through hole structure; or
the first coupling capacitor and/or the second coupling capacitor is obtained by the interdigital structure between the corresponding resonator and the corresponding electrical connection through hole structure.

23. A method for improving the suppression level of a filter, the filter being the band pass filter according to any one of claims 1-11, wherein the method comprises the step of:
adjusting at least one of the first coupling capacitor and the second coupling capacitor, so that the transmission zero point of a signal moves from the roll-off edge frequency on the right side edge of a pass band of the filter to high frequency.

24. A method for improving the suppression level of a filter, the filter being the band pass filter according to any one of claims 12-22, wherein the method comprises the step of:
adjusting at least one of the first coupling capacitor and the second coupling capacitor, so that the transmission zero point of a signal moves from the roll-off edge frequency on the left side edge of a pass band of the filter to low frequency.

25. A duplexer, comprising:
a transmitting filter; and
a receiving filter,
wherein:
the transmitting filter comprises the band pass filter according to any one of claims 1-11, and the receiving filter comprises the band pass filter according to any one of claims 12-22.

26. Electronic equipment, having the band pass filter according to any one of claims 1-22.
